# EUROPEAN PATENT APPLICATION

(11) **EP 4 700 830 A1**
(43) Date of publication of application: **25.02.2026**
(21) Application number: 25170954.9
(22) Date of filing: 16.04.2025
(51) Int. Cl.: H01L 23/528, G06F 30/392, H01L 21/768, H10D 89/10

(54) **SEMICONDUCTOR INTEGRATED CIRCUITS IN BACKSIDE POWER DISTRIBUTION NETWORK ARCHITECTURE**

(30) Priority: 22.08.2024 KR 20240112880
(71) Applicant: Samsung Electronics Co., Ltd., Suwon-si, Gyeonggi-do 16677 (KR)
(72) Inventor: LEE, Kwangmuk, 16677 Suwon-si, Gyeonggi-do (KR); SIM, Jeonggu, 16677 Suwon-si, Gyeonggi-do (KR); LIM, Jaehyoung, 16677 Suwon-si, Gyeonggi-do (KR); KIM, Byung-Sung, 16677 Suwon-si, Gyeonggi-do (KR); CHUN, Kwanyoung, 16677 Suwon-si, Gyeonggi-do (KR)
(74) Representative: Kuhnen & Wacker Patent- und Rechtsanwaltsbüro PartG mbB

(57) **Abstract**

An integrated circuit (600A) includes an insulating layer; a first conductive layer (613) extending in a first direction (X) in the insulating layer; a second conductive layer (623) that extends in the first direction (X) in the insulating layer; a third conductive layer (633) that extends in the first direction (X) in the insulating layer; a first standard cell (SC1) that includes a first cell boundary (CB_X1) in the insulating layer; and a second standard cell (SC2), wherein the first conductive layer (613) overlaps the first cell boundary (CB_X1) in the first direction (X), wherein the second conductive layer (623) is electrically connected to the first conductive layer (613) and is configured to provide an output pin that outputs a signal that transitions to a plurality of voltage levels of the first standard cell (SC1), and wherein the third conductive layer (633) is electrically connected to the first conductive layer (613) and is configured to provide an input pin that receives a signal from the second standard cell (SC2).

## Description

### BACKGROUND OF THE INVENTION

The present disclosure may relate to electronic devices. Specifically, the present disclosure may relate to semiconductor integrated circuits in a backside power distribution network architecture.

Integrated circuits that process digital signals may be designed using standard cells. A functional circuit may be formed by disposing and routing standard cells so that the integrated circuit implements the desired function.

Meanwhile, as demands for high performance, high speed, and/or multi-functionality of integrated circuits increase, the integration density of integrated circuits is increasing. With the trend towards higher integration of integrated circuits, various studies are actively being conducted on a backside power distribution network architecture that disposes a power distribution network on the back of the substrate to route signals provided to standard cells in order to improve (e.g., minimize) routing congestion.

### SUMMARY OF THE INVENTION

An embodiment of the present disclosure may provide a semiconductor integrated circuit in a backside power distribution network (BSPDN) architecture capable of improving (e.g., reducing or minimizing) routing congestion and improving (e.g., optimizing) the area of the integrated circuit.

An integrated circuit according to some embodiments may include a substrate; an insulating layer on the substrate; a first conductive layer that extends in a first direction in the insulating layer, wherein the first direction is parallel with an upper surface of the substrate; a second conductive layer that extends in the first direction in the same layer as the first conductive layer; a third conductive layer that extends in the first direction in the insulating layer; a first standard cell that includes a first cell boundary in the same layer as the first conductive layer; and a second standard cell, wherein the first conductive layer overlaps the first cell boundary in the first direction, wherein the second conductive layer is electrically connected to the first conductive layer and is configured to provide an output pin that outputs a signal that transitions to a plurality of voltage levels of the first standard cell, and wherein the third conductive layer is electrically connected to the first conductive layer and is configured to provide an input pin that receives a signal from the second standard cell.

An integrated circuit according to some embodiments may include a substrate; an insulating layer on the substrate; a standard cell in the insulating layer, wherein cell boundaries of the standard cell extend in a first direction that is parallel with an upper surface of the substrate; a pin between the cell boundaries in a second direction that is parallel with the upper surface of the substrate and intersects the first direction, wherein the pin is configured to transmit a signal that transitions to a plurality of voltage levels; and a conductive layer in the insulating layer and in the same layer as the pin, wherein the conductive layer overlaps at least one of the cell boundaries of the standard cell in the first direction, and wherein the conductive layer is electrically connected to the pin and configured to transmit the signal.

A semiconductor device according to some embodiments may include a substrate that includes a first cell region and a second cell region; a power distribution network (PDN) on a first surface of the substrate; a first insulating layer, wherein the first insulating layer includes a first source/drain region that is electrically connected to the PDN through a backside source/drain contact that extends into the substrate through a second surface of the substrate that is opposite to the first surface, a second source/drain region that is electrically connected to a plurality of conductive layers through a first frontside source/drain contact and is spaced apart from the first source/drain region in a first direction that is parallel with the first surface of the substrate, and a third source/drain region that is electrically connected to the plurality of conductive layers through a second frontside source/drain contact, wherein the first source/drain region and the second source/drain region are in the first cell region, and the third source/drain region is disposed in the second cell region; and a second insulating layer on the first insulating layer, wherein the second insulating layer includes a first conductive layer that is a lowest conductive layer among the plurality of conductive layers extends in a second direction that is parallel with the first surface of the substrate and perpendicular to the first direction, and is electrically connected to the first frontside source/drain contact, a second conductive layer that is electrically connected to the second frontside source/drain contact, and a third conductive layer that is electrically connected to the first conductive layer and the second conductive layer. The first cell region may comprise a first cell boundary that extends in the second direction and a second cell boundary that is spaced apart from the first cell boundary in the first direction. The third conductive layer may overlap the second cell boundary.

### BRIEF DESCRIPTION OF THE DRAWINGS

FIG. 1 is a flowchart illustrating a method of designing and manufacturing an integrated circuit according to some embodiments.
FIG. 2 is a layout diagram of an integrated circuit according to some embodiments.
FIG. 3 is a layout diagram of a standard cell according to some embodiments.
FIG. 4 is a cross-sectional view of a standard cell along line A-A' of FIG. 3.
FIG. 5 is a layout diagram of an integrated circuit according to some embodiments.
FIG. 6A is a layout diagram of an integrated circuit according to some embodiments.
FIG. 6B is a layout diagram of an integrated circuit according to some embodiments.
FIG. 7 is a cross-sectional view of the integrated circuit along line B-B' of FIG. 6A.
FIG. 8 is a layout diagram of an integrated circuit according to some embodiments.
FIG. 9 is a layout diagram of an integrated circuit according to some embodiments.
FIG. 10 is a layout diagram of an integrated circuit according to some embodiments.
FIG. 11 is a layout diagram of an integrated circuit according to some embodiments.
FIG. 12 is a layout diagram of an integrated circuit according to a comparative example.
FIG. 13 illustrates the area reduction effect of an integrated circuit designed according to some embodiments.
FIG. 14 schematically illustrates a design system for an integrated circuit according to some embodiments.
FIG. 15 illustrates a semiconductor device according to some embodiments.

### DETAILED DESCRIPTION

Hereinafter, embodiments of the present disclosure will be described in detail with reference to the accompanying drawings. For identical components on a drawing, the same reference numerals may be used, and duplicate descriptions of identical components may be omitted unless clearly described otherwise.

It should be understood that the embodiments described herein are intended to implement various features of the present disclosure. These are only examples and are not intended to be limiting. For example, the dimensions of the components are not limited to the disclosed ranges or values and may vary depending on process conditions and/or desired device properties. Additionally, the formation of a first structure on or above a second structure in the following description may include embodiments in which the first and second structures are formed in direct contact, and may also include embodiments in which additional structures may be formed between the first and second structures so that the first and second structures do not directly contact each other. For simplicity and clarity, the various structures can be drawn arbitrarily at different scales. As used herein, the term "and/or" includes any and all combinations of one or more of the associated listed items.

Spatially relative terms, such as "beneath," "below," "lower," "above," "upper" and the like, may be used herein for ease of description to describe one element or feature's relationship to another element(s) or feature(s) as illustrated in the drawings.

The drawings and description are to be regarded as illustrative in nature and not restrictive, and like reference numerals may designate like elements throughout the specification unless clearly illustrated or stated otherwise. In the flowchart described with reference to drawings in this description, the operation order may be changed, several operations may be merged, certain operations may be divided, and specific operations may not be performed.

In the description, expressions described in the singular in this specification may be interpreted as the singular or plural unless an explicit expression such as "one" or "single" is used. While terms including ordinal numbers, such as "first" and "second," etc., may be used to describe various components, such components are not limited to the above terms. These terms are only used to distinguish one constituent element from another constituent element.

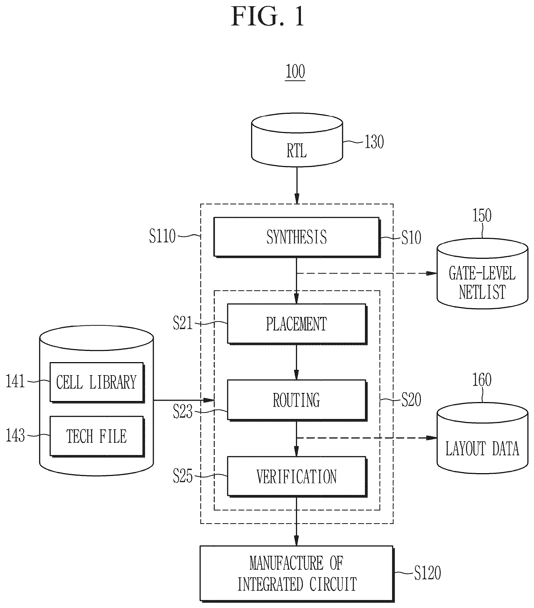

FIG. 1 is a flowchart illustrating a method of designing and manufacturing an integrated circuit according to some embodiments.

Referring to FIG. 1, a method of designing and manufacturing an integrated circuit 100 may include a step of designing an integrated circuit (S110) and a step of manufacturing an integrated circuit (S120).

The step of designing an integrated circuit (S110) may be a step of generating a gate-level netlist 150, designing layout data 160 for a circuit, and verifying it, which may be performed in a design tool for designing and verifying an integrated circuit.

The step of designing an integrated circuit (S110) may include a logic synthesis step (S10) and a physical design step (S20). The logic synthesis step (S10) may refer to a step of generating the gate-level netlist 150 from RTL data 130. For example, an integrated circuit design tool (e.g., a logic synthesis tool) may perform logic synthesis to generate the gate-level netlist 150 (hereinafter may be referred to as a "netlist") from the RTL data 130 written in an hardware description language (HDL) such as VHSIC hardware description language (VHDL) and Verilog. The gate-level netlist 150 may refer to a logical schematic that expresses the connection relationship between cells within an integrated circuit.

The physical design step (S20) may include a placement step (S21), a routing step (S23), and a verification step (S25). The integrated circuit design tool may receive a cell library 141 and a tech file 143, and perform each step based on them.

In the placement step (S21), standard cells may be disposed. For example, the integrated circuit design tool (e.g., P&R tool) may dispose (e.g., locate or position) the standard cells used in the gate-level netlist 150. The integrated circuit design tool may dispose (e.g., locate or position) the standard cells along predefined rows based on information about the standard cells stored in the cell library 141. The cell library 141 may include layout information such as height, size, and geometric information of patterns forming the standard cells for the standard cells, as well as characteristic information such as delay and leakage current for the standard cells.

Here, the standard cells may include logic elements such as AND, OR, inverters, and memory elements such as flip-flops. The standard cell may be implemented by a transistor, a metal oxide semiconductor field effect transistor (MOSFET), a FinFET, etc., but are not limited thereto.

In the routing step (S23), pins of standard cells may be routed. For example, the integrated circuit design tool may (electrically) connect pins of standard cells disposed in the placement step (S21) based on the connection relationship of standard cells in the gate-level netlist 150. Standard cells may include power pins for transmitting and receiving power voltage or ground voltage and signal pins for transmitting and receiving logic signals. Hereinafter, pins of standard cells may refer to signal pins.

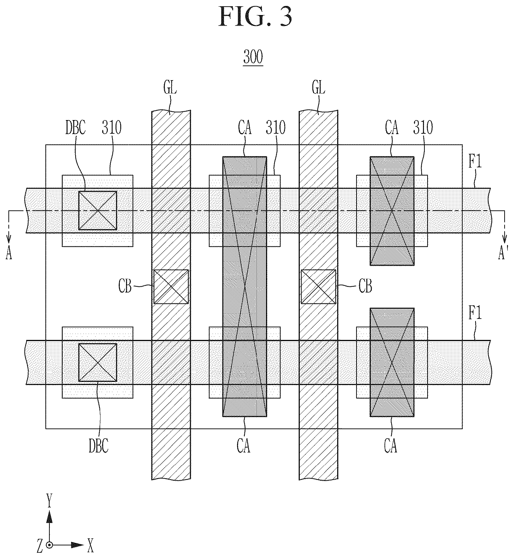

An integrated circuit may include layers (electrically) connecting standard cells. Specifically, the integrated circuit may include layers stacked in a third direction (e.g., the Z direction in FIG. 3). For example, a second layer may be formed on the first layer, which is the lowest layer among a plurality of layers. Additionally, a third layer may be formed on the second layer. Each layer may be (electrically) connected through vias formed on the layer, and the layers and vias may (electrically) connect the pins of standard cells. The plurality of layers may extend intersecting (e.g., overlapping in the third direction (e.g., the Z direction in FIG. 3)) each other.

For example, a first layer, which is the lowest layer among a plurality of layers, may extend in a first direction (e.g., the X direction in FIG. 3), and a second layer formed on the first layer may extend in a second direction (e.g., the Y direction in FIG. 3) intersecting the first direction. Additionally, the third layer formed on the second layer may extend in the first direction in the same manner as (or a similar manner to) the first layer, and the fourth layer formed on the third layer may extend in the second direction in the same manner as (or a similar manner to) the second layer. Hereinafter, the first layer and the third layer, etc. extending in the first direction may be referred to as horizontal layers, and the second layer and the fourth layer, etc. extending in the second direction may be referred to as vertical layers. Each of the layers and vias may include (e.g., may be formed of), but is not limited to, metal, conductive metal nitride, metal silicide, and/or a combination thereof. Hereinafter, layers for (electrically) connecting standard cells may be referred to as conductive layers or metal layers.

The integrated circuit design tool may generate a plurality of metal layers based on information stored in the tech file 143. The tech file 143 may include information about a plurality of metal layers and plurality of vias. For example, the tech file 143 may define the names of metal layers and vias, the width, spacing, and area of the metal layers and vias according to design rules. The tech file 143 may define the minimum and maximum widths for a first metal layer. In some embodiments, the integrated circuit design tool may generate first metal layers of various widths based on the tech file 143 and use the first metal layers to (electrically) connect pins of the standard cells.

The plurality of metal layers may be formed along a plurality of tracks formed on the integrated circuit. For example, the first metal layer may be formed along first tracks extending in the first direction, a second metal layer may be formed along second tracks extending in the second direction intersecting the first direction, and a third metal layer may be formed along third tracks extending in the first direction. The first tracks extending in the first direction may be disposed (e.g., arranged or spaced apart from each other) in the second direction and may be parallel to each other. The second tracks extending in the second direction may be disposed (e.g., arranged or spaced apart from each other) in the first direction and may be parallel to each other. The third tracks extending in the first direction may be disposed (e.g., arranged or spaced apart from each other) in the second direction and may be parallel to each other. The first and third tracks may be identical or different.

In the routing step (S23), the integrated circuit design tool may create interconnection paths that connect pins of standard cells and transmit and receive logic signals. Specifically, the integrated circuit design tool may form a first path, which is an interconnection path between a first pin and a second pin, by connecting the first pin of a first standard cell for transmitting and receiving a logic signal and the second pin of a second standard cell for transmitting and receiving a logic signal using a plurality of metal layers. In some embodiments, the plurality of metal layers forming the first path may include the first metal layer.

The integrated circuit design tool may generate the layout data 160 defining the disposed standard cells and the plurality of metal layers and vias generated. The layout data 160 may have, for example, a format such as GDSII, and may include geometric information of cells and the plurality of metal layers and vias.

The verification step (S25) may be a step for verifying and modifying the generated layout. Verification items may include, but are not limited to, static timing analysis (STA), which verifies that the layout satisfies the timing conditions of the design; design rule check (DRC), which verifies that the layout is properly aligned with the design rules; electronic rule check (ERC), which verifies that the layout is properly aligned without internal electrical disconnections; and layout versus schematic (LVS), which verifies that the layout matches the netlist.

The step of manufacturing an integrated circuit (S120) may include a plurality of steps for manufacturing a mask and forming a semiconductor package.

The step of manufacturing an integrated circuit (S120) may include a step of performing optical proximity correction (OPC), etc. on the layout data 160 generated in the step of designing an integrated circuit (S110) to generate mask data for forming various patterns of a plurality of metal layers, and a step of manufacturing a mask using the mask data. In the step of manufacturing an integrated circuit (S120), various types of exposure and etching processes may be performed (repeatedly). The processes allow for the sequential formation of patterns on the silicon substrate that are organized in the layout design.

Additionally, in the step of manufacturing an integrated circuit (S120), a packaging process may be performed to mount a semiconductor device generated by the integrated circuit on a PCB and mold the semiconductor device with a molding material. The packaging process may allow semiconductor devices to be flipped or bonded onto a substrate using a plurality of contact members.

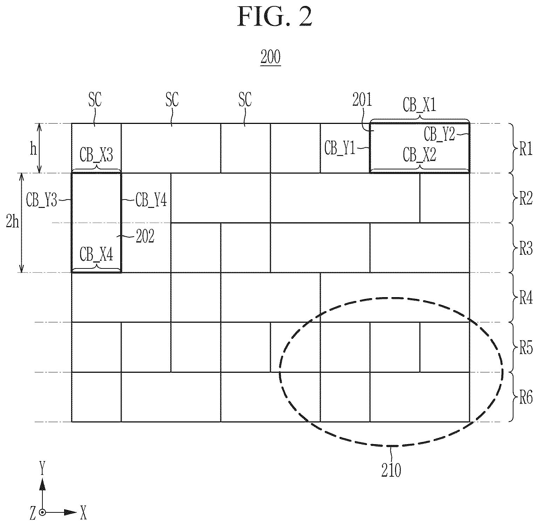

FIG. 2 is a layout diagram of an integrated circuit according to some embodiments.

Referring to FIG. 2, an integrated circuit 200 may include a plurality of standard cells SC including circuit patterns for forming various circuits. The plurality of standard cells SC may have the function to perform various logical functions. In example embodiments, the plurality of standard cells SC may include or be one of logic elements such as ANDs, ORs, inverters, and memory elements such as latches, flip-flops, and the like. Meanwhile, although not shown here, the integrated circuit 200 may further include physical cells such as filler cells.

The standard cell SC may include a cell boundary. The size of the standard cell SC may be determined by the cell boundary. Specifically, the standard cell SC may be defined by the cell boundary, and the integrated circuit design tool may recognize the standard cell SC by using the cell boundary. For example, the cell boundary of a first standard cell 201 may include cell boundaries CB_X1 and CB_X2 in the first direction (e.g., X direction) and cell boundaries CB_Y1 and CB_Y2 in the second direction (e.g., Y direction) perpendicular to the first direction (e.g., X direction). The cell boundary of a second standard cell 202 may include cell boundaries CB_X3 and CB_X4 in the first direction (e.g., X direction) and cell boundaries CB_Y3 and CB_Y4 in the second direction (e.g., Y direction).

The integrated circuit design tool may predefine a plurality of rows R1, R2, R3, R4, R5, and R6 extending in the first direction (e.g., X direction) on the integrated circuit 200. The integrated circuit design tool may dispose the plurality of standard cells SC along the plurality of rows R1, R2, R3, R4, R5, and R6. The plurality of rows R1, R2, R3, R4, R5, and R6 may be regions where the standard cells are disposed. Each of the plurality of rows R1, R2, R3, R4, R5, and R6 may extend in the first direction (e.g., X direction) and be disposed (e.g., arranged) in the second direction (e.g., Y direction). The integrated circuit design tool may dispose the plurality of standard cells SC along the plurality of rows R1, R2, R3, R4, R5, and R6. For example, the first standard cell 201 may be disposed along the first row R1, and the second standard cell 202 may be disposed along the second row R2 and the third row R3. Although the number of the plurality of rows illustrated in FIG. 2 is six (6), the number of the plurality of rows may vary.

The heights of the plurality of standard cells SC in the second direction (e.g., Y direction) may be the same or different from each other. Specifically, the height of the plurality of standard cells SC in the second direction (e.g., Y direction) may be determined according to the length of the rows in which the standard cells are disposed in the second direction (e.g., Y direction). For example, a height h of the first standard cell 201 in the second direction (e.g., Y direction) may be equal to the length of the first row R1 in which the first standard cell 201 is disposed in the second direction (e.g., Y direction). Hereinafter, such standard cells may be referred to as single row cells. In some embodiments, a height 2h of the second standard cell 202 in the second direction (e.g., Y direction) may be equal to the length of the plurality of rows R2 and R3 in which the second standard cell 202 is disposed in the second direction (e.g., Y direction). Hereinafter, such standard cells may be referred to as multi row cells. However, and not limited thereto, a multi row cell may include standard cells having a cell height of 3h or more.

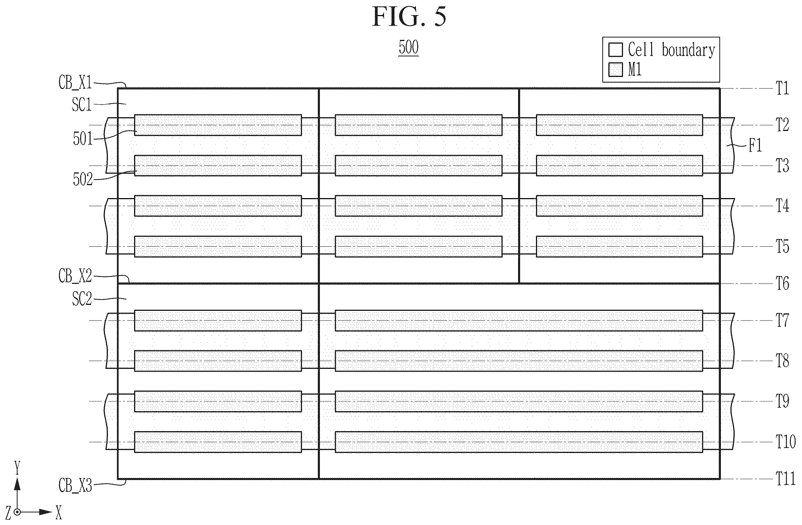

FIG. 2 illustrates the integrated circuit 200 including six rows R1, R2, R3, R4, R5, and R6, but this is merely an example, and the integrated circuit 200 may include a different number of rows, and one row may include a different number of standard cells. Meanwhile, a description of a region 210 of the integrated circuit 200 will be described later with reference to FIGS. 5 to 8.

FIG. 3 is a layout diagram of a standard cell according to some embodiments.

Referring to FIG. 3, a standard cell 300 is one of the plurality of standard cells SC disposed in the integrated circuit (e.g., the integrated circuit 200 of FIG. 2), and the standard cell 300 may include more configurations in addition to the configuration of FIG. 3.

The integrated circuit design tool may design an integrated circuit using the standard cell 300 generated by a cell library (e.g., the cell library141 in FIG. 1). The standard cell 300 may include a circuit pattern having a layout designed according to a placement and routing (PnR) technique to perform at least one logic function. Specifically, the standard cell 300 may include a plurality of active regions F1, gate lines GL, source/drain regions 310, and source/drain contacts CA.

Referring to FIG. 3, the standard cell 300 may include the plurality of active regions F1. The plurality of active regions F1 may extend in the first direction (e.g., X direction) and be disposed (e.g., arranged or spaced apart from each other) in the second direction (e.g., Y direction). The plurality of active regions F1 may be parallel to each other. An active pattern formed in the plurality of active regions F1 may intersect (e.g., overlap in the third direction) the gate line GL to form a transistor.

The plurality of gate lines GL may be disposed on the plurality of active regions F1. The plurality of gate lines GL may each extend in the second direction (e.g., Y direction) intersecting the first direction (e.g., X direction). The plurality of gate lines GL may overlap at least a portion of the plurality of active regions F1 on a XY plane. The gate line GL may include (e.g., may be formed of) any material having electrical conductivity. A gate contact CB may be disposed on the gate line GL. The gate line GL may be (electrically) connected to a plurality of metal layers within the integrated circuit 200 through the gate contact CB.

The plurality of source/drain regions 310 may be formed in the plurality of active regions F1, and the plurality of source/drain contacts CA in contact with the source/drain regions 310 may be formed. The source/drain contact CA may be (electrically) connected to some of the source/drain regions 310 formed in the plurality of active regions F1. The source/drain contact CA may extend in a third direction (e.g., Z direction) from the plurality of active regions F1. The source/drain contact CA may (electrically) connect the plurality of metal layers and source/drain regions 310 within the integrated circuit 200 through a via. Hereinafter, the source/drain contacts CA disposed in the third direction (e.g., Z direction) from the plurality of active regions F1 may be referred to as frontside source/drain contacts. The source/drain region of the standard cell 300 according to some embodiments may transmit and receive logic signals through the frontside source/drain contact CA from the plurality of metal layers. Among the source/drain regions 310 of the standard cell 300 according to some embodiments, a source/drain region 310 (electrically) connected to the frontside source/drain contact CA may correspond to a signal pin of the standard cell 300.

A backside source/drain contact DBC may be formed at the opposite side (e.g., the opposite side in the third direction (e.g., Z direction)) of the frontside source/drain contact CA based on (with respect to) the plurality of source/drain regions 310. The backside source/drain contact DBC may be (electrically) connected to some of the source/drain regions 310 formed in the plurality of active regions F1. The backside source/drain contact DBC may (electrically) connect the plurality of source/drain regions (e.g., the source/drain regions 310) and a backside conductive pattern described below. The source/drain region 310 of the standard cell 300 according to some embodiments may receive a power voltage and/or a ground voltage from the backside conductive pattern through the backside source/drain contact DBC. Among the source/drain regions 310 of the standard cell 300 according to some embodiments, a source/drain region 310 (electrically) connected to the backside source/drain contact DBC may correspond to a power pin of the standard cell 300.

Each of the plurality of source/drain regions 310 may be (electrically) connected to one of the frontside source/drain contacts CA and the backside source/drain contacts DBC.

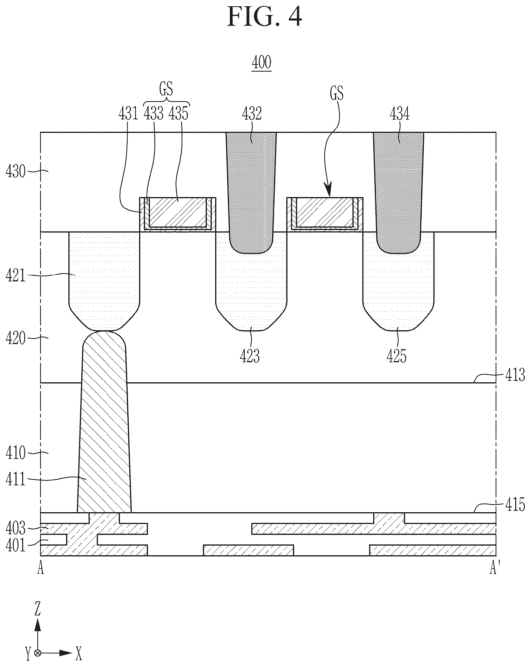

FIG. 4 is a cross-sectional view of a standard cell along line A-A' of FIG. 3.

Referring to FIG. 4, a standard cell 400 includes a base insulating layer 410, an active region 420 on the base insulating layer 410, and an insulating layer 430 on the active region 420, and may include various patterns formed within each layer. Additionally, the standard cell 400 may include a backside insulating layer 401 and a backside conductive pattern 403 formed on (in) the backside insulating layer 401. However, the structure of the standard cell 400 is not limited thereto. For example, the standard cell 400 may further include additional layers between each layer, or may not include some of the layers described above, or may further include additional configurations formed in each layer, or may not include some of the configurations formed in each layer described above or described later.

Referring to FIG. 4, the standard cell 400 may include the base insulating layer 410. The base insulating layer 410 may be a substrate or an insulating substrate. The base insulating layer 410 may include, for example, an oxide, a nitride, an oxynitride, and/or a combination thereof.

The standard cell 400 may include the active region 420. The active region 420 may be disposed on a first surface 413 of the base insulating layer 410 and may have a thickness in the third direction (e.g., Z direction). Source/drain regions 421, 423, and 425 may be formed in the active region 420. The source/drain regions 421, 423, and 425 may be spaced apart from each other in the first direction (e.g., X direction).

The standard cell 400 may include the insulating layer 430 on the active region 420. The insulating layer 430 may include a plurality of gate structures GS and source/drain contacts 432 and 434. The plurality of gate structures GS may be disposed on the active region 420. The plurality of gate structures GS may be spaced apart from each other in the first direction (e.g., X direction) and may extend in the second direction (e.g., Y direction). The gate structure GS may include a gate electrode 435 and a gate insulating layer 433. The gate insulating layer 433 may extend along the side surface of a gate spacer 431. The gate structure GS may be disposed between the source/drain regions 421 and 423 and/or the source/drain regions 423 and 425 (in the first direction (e.g., X direction)). The source/drain regions 421, 423, and 425 and the gate structure GS may form a transistor.

The source/drain contacts 432 and 434 may be spaced apart from each other in the first direction (e.g., X direction) and may extend in the third direction (e.g., Z direction) that is perpendicular to the first direction (e.g., X direction) and the second direction (e.g., Y direction) through the insulating layer 430. For example, the source/drain contacts 432 and 434 may extend into the insulating layer 430 (in the third direction). The source/drain contacts 432 and 434 may electrically contact the source/drain regions 423 and 425. For example, the source/drain contacts 432 and 434 may extend into the source/drain regions 423 and 425 (respectively). The source/drain contacts 432 and 434 may (electrically) connect the plurality of metal layers formed on the insulating layer 430 and the source/drain regions 423 and 425. The source/drain regions 423 and 425 may receive and send electrical signals, etc. from and to other standard cells or supply electrical signals, etc. through the source/drain contacts 432 and 434.

The standard cell 400 may include a backside source/drain contact 411 (electrically) connecting the source/drain region 421 and the backside conductive pattern 403. The backside source/drain contact 411 may extend into (e.g., penetrate) the base insulating layer 410 and the active region 420 in the third direction (e.g., Z direction). Accordingly, the backside source/drain contact 411 may contact with a portion of the source/drain region 421. In some embodiments, the backside source/drain contact 411 may have a width that gradually narrows in the horizontal direction (e.g., the first direction and/or the second direction) from a second surface 415 of the base insulating layer 410 toward the source/drain region 421. That is, the backside source/drain contact 411 may have a tapered shape in the third direction (e.g., Z direction). The second surface 415 may be opposite to the first surface 413 in the third direction. For example, the first surface 413 and the second surface 415 may be an upper surface and a lower surface of the base insulating layer 410, respectively. The backside source/drain contact 411 may include, for example, a metal, a metal alloy, a conductive metal nitride, a conductive metal carbide, and/or a conductive metal oxide.

The standard cell 400 may include the backside insulating layer 401. The backside insulating layer 401 may be disposed on the second surface 415 of the base insulating layer 410. The upper surface of the backside insulating layer 401 may be in contact with a portion of the lower surface of the backside source/drain contact 411. The backside insulating layer 401 may include the backside conductive pattern 403. The backside conductive pattern 403 may include conductive patterns spaced apart in the third direction (e.g., Z direction) and vias connecting (at least) two conductive patterns. In some embodiments, an externally supplied power voltage or the like may be provided to the source/drain region 421 through the backside conductive pattern 403 and the backside source/drain contact 411. Specifically, the standard cell 400 may receive power voltage, etc. from the outside through the backside conductive pattern 403 and the backside source/drain contact 411. Accordingly, the plurality of metal layers formed on the insulating layer 430 of the standard cell 400 according to some embodiments may not supply power voltage, etc. to the standard cell 400. As used hereinafter, the terms "external/outside configuration", "external/outside device", "external/outside power", "external/outside signal", or "outside" are intended to broadly refer to a device, circuit, block, module, power, and/or signal that resides externally (e.g., outside of a functional or physical boundary) with respect to a given circuit, block, module, system, or device.

Meanwhile, although the standard cell 400 is illustrated as being formed as a FinFET, the active pattern formed on the active region 420 within the standard cell 400 may be formed in various shapes. For example, the standard cell 400 may be formed as a gate-all-around (GAA) transistor in which nanowires are surrounded by gate lines on an active region, or may be formed as a multi bridge channel (MBC) transistor in which a plurality of nanosheets are stacked on an active region and gate lines surround the nanosheets, but is not limited thereto.

FIG. 5 is a layout diagram of an integrated circuit according to some embodiments. Specifically, an integrated circuit 500 may correspond to the region 210 of the integrated circuit of FIG. 2, and the standard cells of the integrated circuit 500 may receive power voltage, etc. from the outside through the backside conductive pattern (e.g., backside conductive pattern 403 of FIG. 4) and the backside source/drain contact (e.g., backside source/drain contact 411 of FIG. 4).

Referring to FIG. 5, a plurality of tracks on which the plurality of metal layers are disposed may be defined on the integrated circuit 500. For example, a plurality of tracks T1, T2, T3, T4, T5, T6, T7, T8, T9, T10, and T11 extending in the first direction (e.g., X direction) may be defined on the integrated circuit 500. The plurality of tracks T1, T2, T3, T4, T5, T6, T7, T8, T9, T10, and T11 may extend in the first direction (e.g., X direction) and be disposed (arranged or spaced apart from each other) in the second direction (e.g., Y direction). The plurality of tracks T1, T2, T3, T4, T5, T6, T7, T8, T9, T10, and T11 may be parallel to each other. A first metal layer M1 may be disposed along the plurality of tracks T1, T2, T3, T4, T5, T6, T7, T8, T9, T10, and T11 extending in the first direction (e.g., X direction). For example, the first metal layer M1 may be overlapped in a third direction (e.g., in the Z direction) to the plurality of tracks T1, T2, T3, T4, T5, T6, T7, T8, T9, T10, and T11 extending in the first direction (e.g., X direction).

In some embodiments, some of the tracks T1, T6 and T11 among the plurality of tracks T1, T2, T3, T4, T5, T6, T7, T8, T9, T10, and T11 may overlap boundaries CB_X1, CB_X2, and CB_X3 of the plurality of standard cells SC in the first direction (e.g., X direction), and the remaining tracks T2, T3, T4, T5, T7, T8, T9, and T10 may be disposed between (between in the second direction (e.g., Y direction)) the boundaries CB_X1, CB_X2, and CB_X3 of the plurality of standard cells SC in the first direction (e.g., X direction).

In some embodiments, the integrated circuit design tool may dispose the first metal layers M1 so as to overlap the plurality of tracks T1, T2, T3, T4, T5, T6, T7, T8, T9, T10, and T11. For example, the first metal layers M1 included in an interconnection path through which logic signals of standard cells are transmitted may be disposed on tracks T1, T6, and T11 that overlap (e.g., overlap in the first direction (e.g., X direction)) the boundaries CB_X1, CB_X2, and CB_X3 of the plurality of standard cells SC extending in the first direction (e.g., X direction) among the plurality of tracks T1, T2, T3, T4, T5, T6, T7, T8, T9, T10, and T11. In some embodiments, the first metal layers M1 corresponding to pins of the plurality of standard cells SC may be disposed on tracks T2, T3, T4, T5, T7, T8, T9, and T10 disposed between (between in the second direction (e.g., Y direction)) boundaries CB_X1 and CB_X2 or CB_X2 and CB_X3 of the plurality of standard cells SC extending in the first direction (e.g., X direction).

In some embodiments, the integrated circuit design tool may generate pins of the standard cells using the first metal layer M1 of the plurality of metal layers. Specifically, the integrated circuit design tool may generate the first metal layer M1 (electrically) connected to the source/drain contact (e.g., source/drain contacts 432 and 434 in FIG. 4) on the active region F1 within the standard cell as a pin of the standard cells. For example, among the plurality of first metal layers M1 on a first standard cell SC1, a first layer 501 may correspond to an input pin of the first standard cell SC1, and among the plurality of first metal layers M1 on the first standard cell SC1, a second layer 502 may correspond to an output pin of the first standard cell SC1. The first layer 501 corresponding to the input pin of the first standard cell SC1 may be disposed along a second track T2, and the second layer 502 corresponding to the output pin of the first standard cell SC1 may be disposed along a third track T3. Hereinafter, the first metal layer M1 corresponding to the pin of the standard cell may be referred to as the pin of the standard cell.

Here, each standard cell is illustrated as overlapping six tracks, but the number of tracks overlapping each standard cell may vary. In addition, the tracks T1, T2, T3, T4, T5, T6, T7, T8, T9, T10, and T11 according to the present disclosure are tracks on which the first metal layer M1 is disposed, a second metal layer M2 may be disposed along tracks extending in the second direction (e.g., Y direction) perpendicular to the first direction (e.g., X direction), and a third metal layer M3 may be disposed along tracks extending in the first direction (e.g., X direction) that are the same as or different from the tracks on which the first metal layer M1 is disposed, but a specific description thereof is omitted herein.

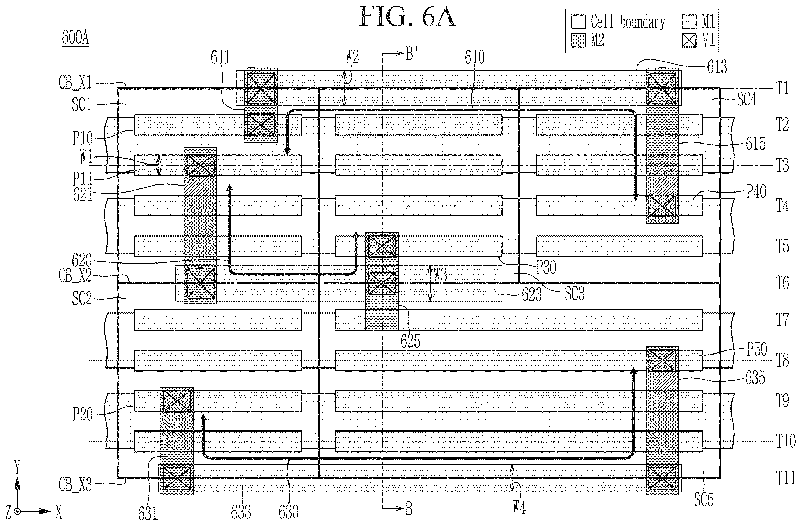

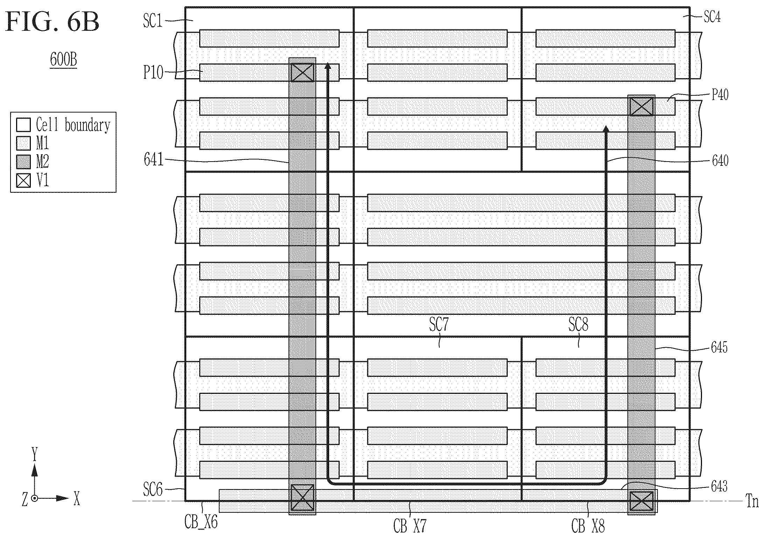

FIGS. 6A and 6B are layout drawings of an integrated circuit according to some embodiments. Specifically, FIGS. 6A and 6B illustrates the first metal layer M1 disposed on an integrated circuit according to some embodiments.

Referring to FIG. 6A, an integrated circuit 600A may include a plurality of interconnection paths that directly (electrically) connect standard cells. For example, the integrated circuit 600A may include a first path 610 (electrically) connecting a pin P10 on the second track T2 of the first standard cell SC1 to a pin P40 on a fourth track T4 of a fourth standard cell SC4. The integrated circuit 600A may include a second path 620 (electrically) connecting a pin P11 on the third track T3 of the first standard cell SC1 and a pin P30 on a fifth track T5 of a third standard cell SC3. The integrated circuit 600A may include a third path 630 (electrically) connecting a pin P20 on a ninth track T9 of a second standard cell SC2 and a pin P50 on an eighth track T8 of a fifth standard cell SC5. Each interconnection path may include the plurality of metal layers.

In some embodiments, the integrated circuit design tool may form interconnection paths using the first metal layer M1, which is the lowest layer among the plurality of layers. In this case, the first metal layer M1 of the interconnection path may be disposed on tracks where the pins of the standard cells are not disposed among the plurality of tracks T1, T2, T3, T4, T5, T6, T7, T8, T9, T10, and T11. Referring to FIG. 6A, the integrated circuit design tool may dispose the first metal layer M1 of an interconnection path on the remaining tracks T1, T6, and T11 except for the tracks T2, T3, T4, T5, T7, T8, T9, and T10 on which the pins of the standard cells are disposed among the plurality of tracks T1, T2, T3, T4, T5, T6, T7, T8, T9, T10, and T11. For example, the first path 610 may include second metal layers 611 and 615 (electrically) connected to the pins P10 and P40 and a first metal layer 613 disposed on the first track T1. The second path 620 may include second metal layers 621 and 625 (electrically) connected to pins P11 and P30 and a first metal layer 623 disposed on a sixth track T6. The third path 630 may include second metal layers 631 and 635 (electrically) connected to pins P20 and P50 and a first metal layer 633 disposed on an eleventh track T11. That is, the tracks on which the pins of the standard cells are formed and the tracks on which the first metal layer M1 included in the interconnection path is disposed may be different from each other. Meanwhile, different types of layers may be (electrically) connected to each other through vias V1.

In some embodiments, the integrated circuit design tool may dispose the first metal layer M1 within an interconnection path on tracks that overlap cell boundaries of standard cells in the first direction (X) among the plurality of tracks T1, T2, T3, T4, T5, T6, T7, T8, T9, T10, and T11. The first track T1 and the sixth track T6 may overlap the cell boundaries CB_X1 and CB_X2 of the first standard cell SC1 in the first direction (e.g., X direction), respectively, and the eleventh track T11 may overlap the cell boundary CB_X3 of the second standard cell SC2 in the first direction (e.g., X direction).

As such, the integrated circuit design tool may dispose the first metal layer M1 included in the interconnection path on tracks where the pins of the standard cells are not formed. The integrated circuit design tool may dispose the first metal layer M1 included in an interconnection path on a track that overlaps the cell boundary of standard cells in the first direction (e.g., X direction). The integrated circuit according to some embodiments may have the advantage of improving (e.g., reducing) routing congestion of the integrated circuit and improving (e.g., optimizing or reducing) the size of the integrated circuit by using the first metal layer M1 as an interconnection path.

In some embodiments, the widths of the first metal layers M1 included in the interconnection paths may be equal or different. Here, the width of the first metal layer M1 may refer to the width of the first metal layer M1 in the second direction (e.g., Y direction).

As described with reference to FIG. 1, the integrated circuit design tool may generate the plurality of metal layers based on the minimum width and maximum width of each metal layer defined in the tech file (e.g., the tech file 143 of FIG. 1). Referring to FIG. 6A, the first metal layer 613 included in the first path 610 may have a second width W2, and the first metal layer 623 included in the second path 620 may have a third width W3. The second width W2 and the third width W3 may be equal or different. The second width W2 and the third width W3 may be greater (larger) than the first width W1 of the first metal layer M1 generated as a pin of the standard cell (e.g., the pin P11). Meanwhile, a fourth width W4 of the first metal layer 633 included in the third path 630 may be less (smaller) than the second width W2 and the third width W3. The fourth width W4 may be equal to or greater than the first width W1. The integrated circuit design tool may use the first metal layer M1 with a relatively great (large) width (e.g., W2 or W3) as the interconnection path to reduce the resistance of the interconnection path. in some embodiments, the integrated circuit design tool may use the first metal layer M1 having a relatively less (small) width (e.g., W4) as the interconnection path to reduce the coupling capacitance of the interconnection path. The integrated circuit design tool may determine and generate the width of the first metal layer M1 of the interconnection path based on the characteristics of the interconnection path and the minimum and maximum widths of the first metal layer M1 defined in a tech file 143.

Meanwhile, the position of the first metal layer M1 included in the interconnection path is not limited thereto. In some embodiments, the first metal layer M1 included in the interconnection path may overlap at least one cell boundary extending in the first direction (e.g., X direction) among the plurality of cell boundaries of the plurality of standard cells included in the integrated circuit on the XY plane. In some embodiment, a position in the second direction (e.g., Y direction) of the first metal layer M1 included in an interconnection path may be substantially same as the position in the second direction (e.g., Y direction) of at least one cell boundary extending in the first direction (e.g., X direction) among the plurality of cell boundaries of the plurality of standard cells included in the integrated circuit. Referring to FIG. 6B, the first standard cell SC1 and the fourth standard cell SC4 of an integrated circuit 600B may be interconnected through a fourth path 640. The fourth path 640 may interconnect the pin P10 of the first standard cell SC1 and the pin P40 of the fourth standard cell SC4. The fourth path 640 may correspond to the first path 610 of FIG. 6A. The fourth path 640 may include second metal layers 641 and 645 (electrically) connected to the pins P10 and P40 and a first metal layer 643 disposed on a nth track Tn. The nth track Tn may be a track that overlaps a cell boundary CB_X6 in the first direction (e.g., X direction) of a sixth standard cell SC6, a cell boundary CB_X7 in the first direction (e.g., X direction) of a seventh standard cell SC7, and a cell boundary CB_X8 in the first direction (e.g., X direction) of an eighth standard cell SC8.

In some embodiments, the first metal layer 643 may overlap the cell boundary CB_X6 in the first direction (e.g., X direction) of the sixth standard cell SC6 among the plurality of standard cells included in the integrated circuit 600B, the cell boundary CB_X7 in the first direction (e.g., X direction) of the seventh standard cell SC7, and/or the cell boundary CB_X8 in the first direction (e.g., X direction) of the eighth standard cell SC8. In some embodiments, the position of the first metal layer 643 in the second direction (e.g., Y direction) may be the same as the position of the cell boundary CB_X6 extending in the first direction (e.g., X direction) of the sixth standard cell SC6 among the plurality of standard cells included in the integrated circuit 600B, the cell boundary CB_X7 in the first direction (e.g., X direction) of the seventh standard cell SC7, and/or the cell boundary CB_X8 in the first direction (e.g., X direction) of the eighth standard cell SC8 in the second direction (e.g., Y direction). As such, there may be various interconnection paths connecting the pins of standard cells.

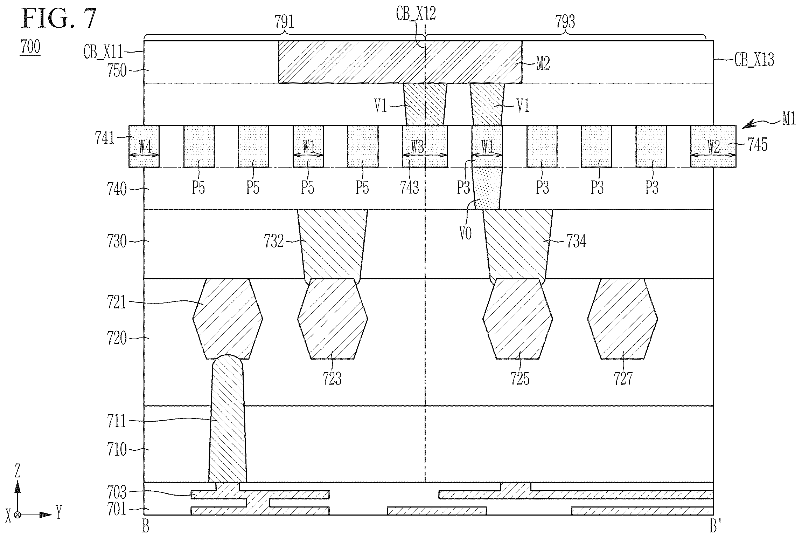

FIG. 7 is a cross-sectional view of the integrated circuit along line B-B' of FIG. 6A.

Referring to FIG. 7, an integrated circuit 700 may include a first cell region 791 and a second cell region 793. Here, the first cell region 791 corresponds to the region of the fifth standard cell SC5 of FIG. 6A, and the second cell region 793 corresponds to the region of the third standard cell SC3 of FIG. 6A.

In some embodiments, the integrated circuit 700 may include a base insulating layer 710, an active region 720, and a plurality of insulating layers 730, 740, and 750 on the active region 720. The integrated circuit 700 may include a plurality of source/drain regions 721, 723, 725, and 727 formed in the active region 720 and a backside source/drain contact 711 extending into (e.g., penetrating) the base insulating layer 710 and the active region 720 and contacting the source/drain region 721. The backside source/drain contact 711 may be (electrically) connected to a backside conductive pattern 703 within a backside insulating layer 701. The source/drain regions 723 and 725 may be (electrically) connected to source/drain contacts 732 and 734 disposed on (in) the insulating layer 730 formed on the active region 720. The structure of the base insulating layer 710, the active region 720, and the plurality of insulating layers 730 on the active region 720 of the integrated circuit 700 is same or similar to the structure of the standard cell 400 of FIG. 4, and therefore, a detailed description thereof may be omitted.

In some embodiments, the integrated circuit 700 may include a via V0 and the plurality of first metal layers M1 disposed on an insulating layer 740 and (electrically) connected to the source/drain contact 734. The plurality of first metal layers M1 may be spaced apart from each other in the second direction (e.g., Y direction). The plurality of first metal layers M1 may include pins P5 of the fifth standard cell SC5 and pins P3 of the third standard cell SC3. Some of the pins P3 and P5 may be (electrically) connected to the source/drain contact 734 through the via V0. The first width W1 of each pin P3 and P5 in the second direction (e.g., Y direction) may be equal.

In some embodiments, the plurality of first metal layers M1 may include first metal layers 741, 743, and 745 within the plurality of interconnection paths. The first metal layers 741, 743, and 745 within the plurality of interconnection paths may be arranged at cell boundaries CB_X11, CB_X12, and CB_X13 extending in the first direction (e.g., X direction) of the standard cells SC3 and SC5. The widths W2, W3, and W4 of the first metal layers 741, 743, and 745 within the plurality of interconnection paths may be equal to or different from each other. The widths W2, W3, and W4 of the first metal layers 741, 743, and 745 within the plurality of interconnection paths may be greater (larger) than the first width W1 of pins P.

In some embodiment, the first metal layer P3 and P5 generated as a pin of the standard cell and the first metal layers 741, 743, and 745 within the plurality of interconnection paths may be disposed on the same layer. A portion of the first metal layer M1 may be (electrically) connected to the second metal layer M2 through the via V1 disposed in an insulating layer 750. Although some metal layers M1 and M2 are shown here, the integrated circuit 700 may include more upper metal layers (such as M3, M4, M5, etc., which may be disposed on M2, but are not shown).

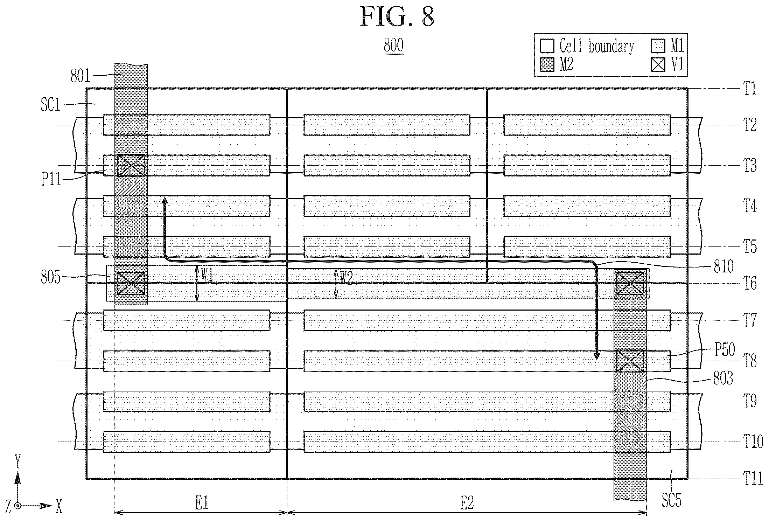

FIG. 8 is a layout diagram of an integrated circuit according to some embodiments.

Referring to FIG. 8, an integrated circuit 800 may include a plurality of standard cells and a plurality of metal layers disposed on the integrated circuit 800. Each metal layer may be disposed along a predefined track. For example, the first metal layer M1 may be disposed along the plurality of tracks T1, T2, T3, T4, T5, T6, T7, T8, T9, T10, and T11 defined on the integrated circuit 800.

In some embodiments, the interconnection path may include a plurality of metal layers. For example, an interconnection path 810 (electrically) connecting a pin P11 of the first standard cell SC1 and the pin P50 of the fifth standard cell SC5 may include a second metal layer 801, a second metal layer 803, and a first metal layer 805 disposed in the sixth track T6. The metal layers may be (electrically) connected to each other through the vias V1. For example, the second metal layer 801 may be (electrically) connected to the pin P11 of the first standard cell SC1 through the via V1, the second metal layer 803 may be (electrically) connected to the pin P50 of the fifth standard cell SC5 through the via V1, and the first metal layer 805 may be (electrically) connected to the second metal layers 801 and 803 through the via V1.

In some embodiments, the width of the first metal layer disposed on a track in an interconnection path may vary depending on the section. Specifically, the first metal layer 805 disposed on the sixth track T6 in the interconnection path 810 may have the first width W1 in a first section E1 and the second width W2 in a second section E2. For example, the integrated circuit design tool may determine a different width of the first metal layer 805 in each section to reduce the resistance of the first metal layer 805 in the first section E1 and improve the coupling capacitance with other layers adjacent to the first metal layer 805 in the second section E2. The integrated circuit design tool may determine the width of the first metal layer 805 differently in each section by considering the characteristics of a standard cell (e.g., the first standard cell SC1) disposed adjacent to the first section E1 and the characteristics of a standard cell (e.g., the fifth standard cell SC5) disposed adjacent to the second section E2. The widths W1 and W2 of the first metal layer 805 may be values between the minimum width and the maximum width of the first metal layer M1 defined in the tech file (the tech file 143 in FIG. 1).

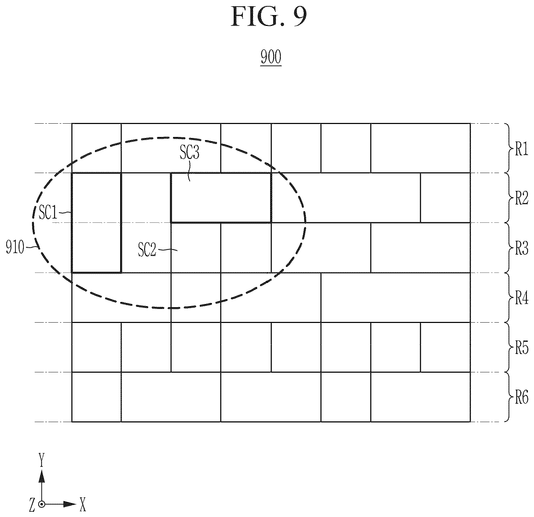

FIG. 9 is a layout diagram of an integrated circuit according to some embodiments. The configuration of an integrated circuit 900 of FIG. 9 is identical or similar to the configuration of the integrated circuit 200 of FIG. 2, so any duplicate description may be omitted.

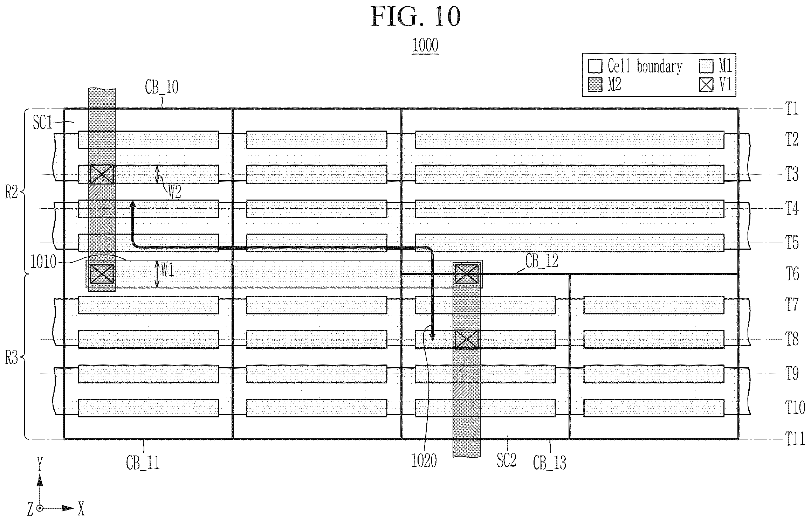

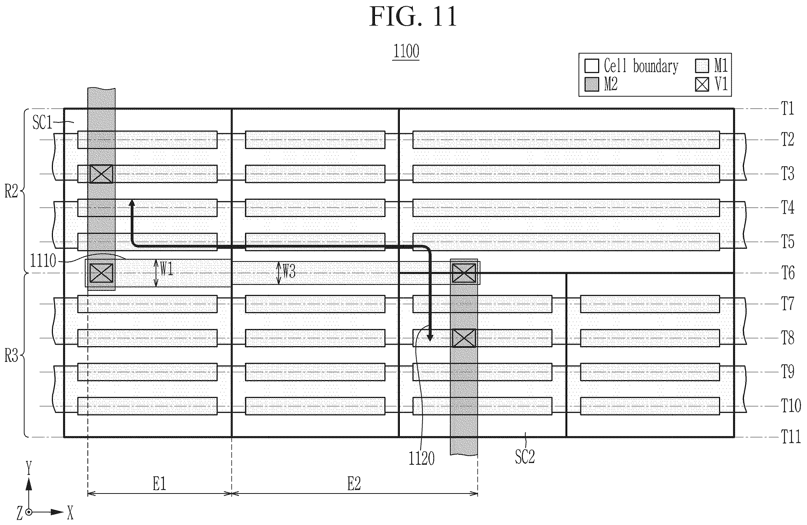

The integrated circuit design tool may dispose the plurality of standard cells SC along the plurality of rows R1, R2, R3, R4, R5, and R6 extending in the first direction (e.g., X direction) on the integrated circuit 900. At this time, the heights of the plurality of standard cells SC in the second direction (e.g., Y direction) may be equal or different from each other. For example, the first standard cell SC1 may be a multi row cell, and the second standard cell SC2 and the third standard cell SC3 may be single row cells. A description of a region 910 of the integrated circuit 900 is provided below with reference to FIGS. 10 and 11.

FIGS. 10 and 11 are layout diagrams of an integrated circuit according to some embodiments. Specifically, integrated circuits 1000 and 1100 may correspond to the region 910 of the integrated circuit (900 of FIG. 9), and the standard cells of the integrated circuit 1000 and 1100 may receive power voltage, etc. from the outside through the backside conductive pattern and the backside source/drain contact.

Referring to FIG. 10, the integrated circuit 1000 may include the plurality of standard cells SC disposed along the plurality of rows R2 and R3 and the plurality of first metal layers M1 disposed along the plurality of tracks T1, T2, T3, T4, T5, T6, T7, T8, T9, T10, and T11. Some of the tracks T1, T6, and T11 among the plurality of tracks T1, T2, T3, T4, T5, T6, T7, T8, T9, T10, and T11 on the integrated circuit 1000 may overlap (e.g., overlap in the first direction (e.g., X direction)) cell boundaries in the first direction (e.g., X direction) of the plurality of standard cells. Specifically, the first track T1 may overlap a cell boundary CB_10 of the first standard cell SC1 in the first direction (e.g., X direction), the sixth track T6 may overlap a cell boundary CB_12 of the second standard cell SC2 in the first direction (e.g., X direction), and the eleventh track T11 may overlap cell boundaries CB_11 and CB_13 of the first standard cell SC1 and the second standard cell SC2 in the first direction (e.g., X direction). Among the plurality of tracks T1, T2, T3, T4, T5, T6, T7, T8, T9, T10, and T11 on the integrated circuit 1000, the positions of some of the tracks T1, T6, and T11 in the second direction (Y) may be the same as the positions of the cell boundaries (of the first direction (e.g., X direction)) of the plurality of standard cells in the second direction (e.g., Y direction). Specifically, the position of the first track T1 in the second direction (e.g., Y direction) may be the same as the position of the cell boundary CB_10 (extending in the first direction (e.g., X direction)) of the first standard cell SC1 in the second direction (e.g., Y direction), the position of the sixth track T6 in the second direction (e.g., Y direction) may be the same as the position of the cell boundary CB_12 (extending in the first direction (e.g., X direction)) of the second standard cell SC2 in the second direction (e.g., Y direction), and the position of the eleventh track T11 in the second direction (e.g., Y direction) may be the same as the positions of the cell boundaries CB_11 and CB_13 (extending in the first direction (e.g., X direction)) of the first standard cell SC1 and the second standard cell SC2 in the second direction (e.g., Y direction).

In some embodiments, the first metal layer included in an interconnection path may be disposed on the track T1, T6, and T11 that overlaps a cell boundary of a standard cell in a first direction (e.g., X direction) among the plurality of tracks T1, T2, T3, T4, T5, T6, T7, T8, T9, T10, and T11. For example, an interconnection path 1020 (electrically) connecting the first standard cell SC1 and the second standard cell SC2 may include a first metal layer 1010 disposed on the sixth track T6 having the same position in the second direction (e.g., Y direction) with the cell boundary CB_12 of the second standard cell SC2 extending in the first direction (e.g., X direction). Meanwhile, without being limited thereto, the interconnection path 1020 (electrically) connecting the first standard cell SC1 and the second standard cell SC2 may include a first metal layer disposed in a track overlapping a cell boundary (extending in the first direction (e.g., X direction)) of a standard cell other than the first standard cell SC1 and the second standard cell SC2 among a plurality of standard cells in the integrated circuit 1000. In some embodiments, the tracks on which the first metal layer included in the interconnection path is disposed may be different from the tracks on which the pins of the standard cells are disposed. Specifically, the position of the first metal layer 1010 included in the interconnection path 1020 in the second direction (e.g., Y direction) may be different from the positions of the pins of the first standard cell SC1 and the second standard cell SC2 in the second direction (e.g., Y direction).

In some embodiments, the width W1 of the first metal layer 1010 within the interconnection path 1020 may be different from the width W2 of the first metal layer output as a pin of the first standard cell SC1. Specifically, the width W1 of the first metal layer 1010 within the interconnection path 1020 may be greater than the width W2 of the first layer output as a pin of the first standard cell SC1. Therefore, the resistance of the interconnection path 1020 may be reduced.

Referring to FIG. 11, in some embodiments, the width of the first metal layer disposed on one track in one interconnection path may vary depending on the section. Specifically, a first metal layer 1110 disposed on the sixth track T6 in the interconnection path 1120 may have the first width W1 in the first section E1 and the third width W3 in the second section E2. For example, the integrated circuit design tool may determine a different width of the first metal layer 1110 in each section to reduce the resistance of the first metal layer 1110 in the first section E1 and improve the coupling capacitance in relation to a layer adjacent to the first metal layer 1110 in the second section E2. The widths W1 and W3 of the first metal layer 1110 may be values between the minimum width and the maximum width of the first metal layer M1 defined in the tech file (e.g., the tech file 143 of FIG. 1).

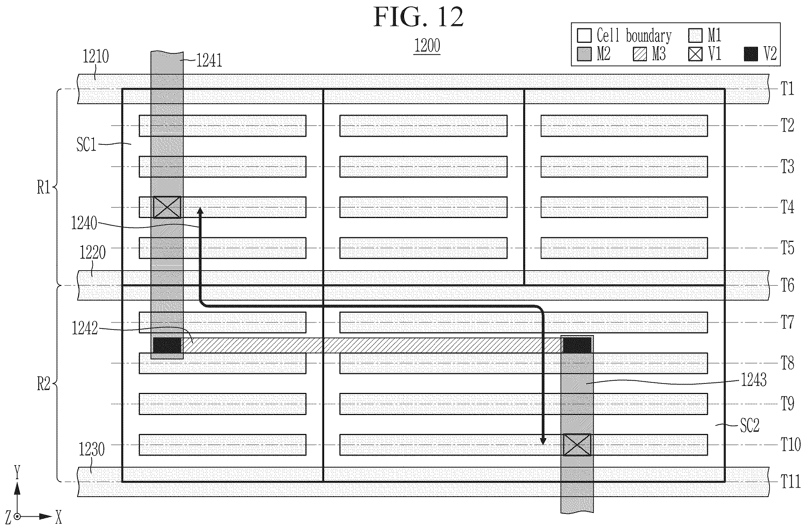

FIG. 12 is a layout diagram of an integrated circuit according to a comparative example.

According to the comparative example, an integrated circuit 1200 may include a plurality of standard cells disposed along the plurality of predefined rows R1 and R2 extending in the first direction (e.g., X direction). A plurality of standard cells may include a plurality of pins disposed along a plurality of tracks.

According to the comparative example, the integrated circuit 1200 may include a plurality of first metal layers 1210, 1220, and 1230 that supply a power voltage and a ground voltage to a plurality of standard cells. The plurality of first metal layers 1210, 1220, and 1230 that supply power voltage and ground voltage to a plurality of standard cells may be disposed as power rails at cell boundaries (extending in the first direction (e.g., X direction)) of the plurality of standard cells. The plurality of first metal layers 1210, 1220, and 1230 may be disposed on the tracks T1, T6, and T11 that overlap cell boundaries (extending in the first direction (X)) of a plurality of standard cells among the plurality of tracks T1, T2, T3, T4, T5, T6, T7, T8, T9, T10, and T11. The plurality of first metal layers 1210, 1220, and 1230 may extend in the first direction (e.g., X direction) and be disposed (e.g., arranged or spaced apart from each other) in the second direction (e.g., Y direction). The plurality of first metal layers 1210, 1220, and 1230 may be parallel to each other.

According to the comparative example, the first metal layer M1 may be disposed on the plurality of tracks T1, T2, T3, T4, T5, T6, T7, T8, T9, T10, and T11 within the integrated circuit 1200. For example, pins of standard cells are disposed on some tracks T2, T3, T4, T5, T7, T8, T9, and T10 among the plurality of tracks T1, T2, T3, T4, T5, T6, T7, T8, T9, T10, and T11, and power rails for providing power voltage and ground voltage to the standard cells are disposed on the remaining tracks T1, T6, and T11 among the plurality of tracks T1, T2, T3, T4, T5, T6, T7, T8, T9, T10, and T11. Therefore, according to the comparative example, the integrated circuit design tool may use the third metal layer M3 and a fifth metal layer M5, etc., excluding the first metal layer M1, as horizontal layers within the interconnection path. Referring to FIG. 12, an interconnection path 1240 (electrically) connecting the first standard cell SC1 and the second standard cell SC2 may include second metal layers 1241 and 1243, and a third metal layer 1242. According to the comparative example, since the metal layers that can be used as interconnection paths are limited, there is a problem in that routing congestion easily occurs and causes an increase in the area of the integrated circuit.

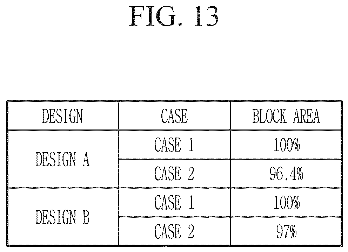

FIG. 13 illustrates the area reduction effect of an integrated circuit designed according to some embodiments.

Referring to FIG. 13, a first case CASE 1 has an integrated circuit including a power rail of the first metal layer M1, and a second case CASE 2 has an integrated circuit that does not include a power rail of the first metal layer M1. Specifically, in the first case CASE 1, the integrated circuit does not use the first metal layer M1 as an interconnection path, and in the second case CASE 2, the integrated circuit uses the first metal layer M1 as an interconnection path.

Looking into a first design DESIGN A, when the area of the first design DESIGN A in the first case CASE 1 is 100%, the area of the first design DESIGN A in the second case CASE 2 is 96.4%. Looking into a second design DESIGN B, when the area of the second design DESIGN B in the first case CASE 1 is 100%, the area of the second design DESIGN B in the second case CASE 2 is 97%.

As such, by using the first metal layer M1 as an interconnection path connecting standard cells rather than power rails, the area of the integrated circuit may be reduced by approximately 3% or more.

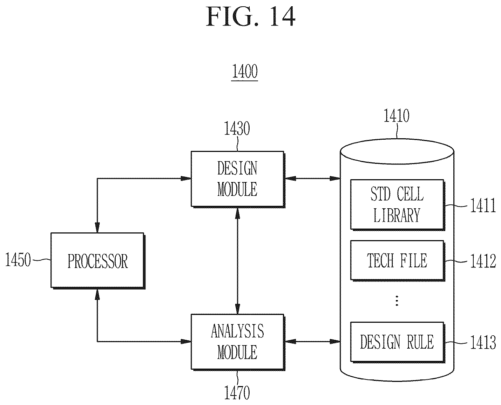

FIG. 14 schematically illustrates a design system for an integrated circuit according to some embodiments.

A design system 1400 may include a storage device 1410, a design module 1430, a processor 1450, and an analysis module 1470. The design system 1400 of FIG. 14 may perform at least a part of the design operations of the integrated circuit described in the method of designing the integrated circuit of FIGS. 1 to 11. The design system 1400 may be implemented as an integrated device and may thus be referred to as a design device. The design system 1400 may be provided as a dedicated device for designing integrated circuits, but may also be a computer for driving various simulation tools or design tools.

The storage device 1410 according to some embodiments may include a standard cell library 1411, a tech file 1412, and a design rule 1413. In some embodiments, the standard cell library 1411 may include layout information about standard cells, and the tech file 1412 may include information about a plurality of layers within an integrated circuit. The standard cell library 1411, the tech file 1412, and the design rule 1413 within the storage device 1410 may be provided from the storage device 1410 to the design module 1430 and the analysis module 1470. The number of cell libraries included in the storage device 1410 may vary.

The design module 1430 according to some embodiments may receive the standard cell library 1411, the tech file 1412, and the design rule 1413 from the storage device 1410 to perform design operations of the integrated circuits of FIGS. 1 to 11. In some embodiments, the design module 1430 may perform a placement operation on standard cells using the standard cell library 1411, and perform a routing operation on the standard cells after generating a plurality of layers according to the tech file 1412. The design module 1430 according to some embodiments may use the first metal layer, which is the lowest metal layer among a plurality of metal layers, as an interconnection path. Specifically, the first metal layer may be disposed on tracks where pins of standard cells are not disposed. A track on which pins of standard cells are not disposed may overlap a cell boundary of the standard cells in the first direction or may overlap a row on which standard cells are disposed. Here, the term "module" may refer to software, hardware such as a field programmable gate array (FPGA) or an application specific integrated circuit (ASIC), or a combination of software and hardware.

The processor 1450 may be used by the design module 1430 and the analysis module 1470 to perform operations. For example, the processor 1450 may include a microprocessor, an application processor AP, a digital signal processor DSP, a graphic processing unit GPU, and the like. Although only one processor 1450 is illustrated in FIG. 14, the design system 1400 may include a plurality of processors depending on embodiments. The processor 1450 may also include cache memory to enhance operational capability.

The analysis module 1470 may perform analysis and verification on the layout generated by the design module 1430 during or after performing the design operations of the integrated circuits of FIGS. 1 to 11. In some embodiments, the analysis module 1470 may analyze and verify whether the standard cells and the plurality of metal layers (electrically) connecting the standard cells satisfy the design rule based on the design rule 1413 received from the storage device 1410.

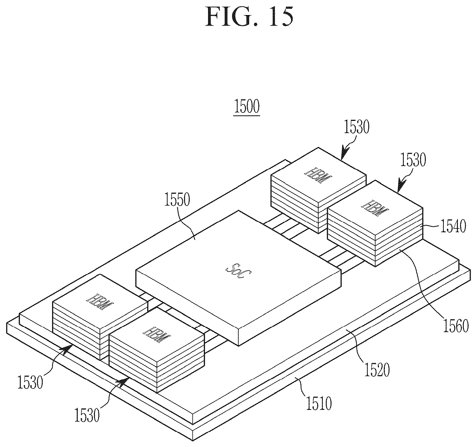

FIG. 15 illustrates a semiconductor device according to some embodiments.

Referring to FIG. 15, a semiconductor device 1500 may be a memory module including at least one stack semiconductor chip 1530 mounted on a package substrate 1510, such as a printed circuit board, and a system-on-chip (SOC) 1550.

An interposer 1520 may optionally be further provided on the package substrate 1510. The stack semiconductor chip 1530 may be formed as a chip-on-chip (CoC). The stack semiconductor chip 1530 may include at least one memory chip 1540 stacked on a buffer chip 1560, such as a logic chip. The buffer chip 1560 and at least one memory chip 1540 may be (electrically) connected to each other by a through silicon via (TSV). In some embodiments, the buffer chip 1560, at least one memory chip 1540, and the system-on-chip 1550 may be designed by the layout method described with reference to FIGS. 1 to 11. Specifically, signal pins of standard cells within the chip may be interconnected using a lowest metal layer among metal layers, and the lowest metal layer may overlap a cell boundary of the standard cells in the first direction. The semiconductor device 1500 according to some embodiments may have a backside power distribution network architecture. Accordingly, it is possible to reduce routing congestion of the semiconductor device 1500 and efficiently utilize the area thereof. In some embodiments, the stack semiconductor chip 1530 may be a high bandwidth memory (HBM), for example, 500 GB/sec to 1 TB/sec, or more.

## Claims

1. An integrated circuit (600A, 600B), comprising:
a substrate (710);
an insulating layer (740) on the substrate (710);
a first conductive layer (613) that extends in a first direction (X) in the insulating layer (740), wherein the first direction (X) is parallel with an upper surface of the substrate (710);
a second conductive layer (623) that extends in the first direction (X) in a same layer as the first conductive layer (613);
a third conductive layer (633) that extends in the first direction (X) in the same layer as the first conductive layer (613);
a first standard cell (SC1) that includes a first cell boundary (CB_X1) in the insulating layer (740); and
a second standard cell (SC2),
wherein the first conductive layer (613) overlaps the first cell boundary (CB_X1) in the first direction (X),
wherein the second conductive layer (623) is electrically connected to the first conductive layer (613) and is configured to provide an output pin that outputs a signal that transitions to a plurality of voltage levels of the first standard cell (SC1), and
wherein the third conductive layer (633) is electrically connected to the first conductive layer (613) and is configured to provide an input pin that receives a signal from the second standard cell (SC2).

2. The integrated circuit (600A, 600B) of claim 1, wherein
the first standard cell (SC1) further includes a second cell boundary (CB_X2) that extends in the first direction (X), and
wherein the second conductive layer (623) is between the first cell boundary (CB_X1) and the second cell boundary (CB_X2) in a second direction (Y) that is parallel with the upper surface of the substrate (710) and intersects the first direction (X).

3. The integrated circuit (600A, 600B) of claim 1 or 2, wherein
the first conductive layer (613), the second conductive layer (623), and the third conductive layer (633) are spaced apart from each other in a second direction (Y) that is parallel with the upper surface of the substrate (710) and intersects the first direction (X).

4. The integrated circuit (600A, 600B) of any one of claims 1 to 3, wherein
the first standard cell (SC1) further includes a second cell boundary (CB_X2) that extends in the first direction (X)
wherein the second standard cell (SC2) includes a third cell boundary (CB_X2) and a fourth cell boundary (CB_X3) that extends in the first direction (X), and
wherein the second conductive layer (623) is between the first cell boundary (CB_X1) and the second cell boundary (CB_X2) in the second direction (Y) and the third conductive layer (633) is between the third cell boundary (CB_X2) and the fourth cell boundary (CB_X3) in the second direction (Y).

5. The integrated circuit (600A, 600B) of any one of claims 1 to 4, wherein
a first width (W2) of the first conductive layer (613) is different from a second width (W3) of the second conductive layer (623).

6. The integrated circuit (600A, 600B) of claim 5, wherein
the first width (W2) of the first conductive layer (613) is different from a third width (W4) of the third conductive layer (633).

7. The integrated circuit (600A, 600B) of claim 6, wherein
the first width (W2) of the first conductive layer (613) is greater than the second width (W3) of the second conductive layer (623) and the third width (W4) of the third conductive layer (633).

8. The integrated circuit (600A, 600B) of any one of claims 1 to 7, wherein
the first conductive layer (613) has a first width (W2) and a second width (W1) that is different from the first width (W2).

9. The integrated circuit (600A, 600B) of any one of claim 1 to 8, further comprising:
a fourth conductive layer on the first conductive layer (613) and the second conductive layer (623), wherein the fourth conductive layer electrically connects the first conductive layer (613) and the second conductive layer (623); and
a fifth conductive layer on the first conductive layer (613) and the third conductive layer (633), wherein the fifth conductive layer electrically connects the first conductive layer (613) and the third conductive layer (633).

10. The integrated circuit (600A, 600B) of claim 9, further comprising:
a sixth conductive layer below the second conductive layer (623), wherein the sixth conductive layer is configured to supply a power voltage to the first standard cell (SC1) through a first source/drain pattern that is electrically connected to the second conductive layer (623) and a second source/drain pattern that is spaced apart from the first source/drain pattern in the first direction (X).

11. The integrated circuit (600A, 600B) of any one of claims 1 to 10, wherein
the second standard cell (SC2) further includes a second cell boundary (CB_X2) extending in the first direction (X), wherein the second cell boundary (CB_X2) is disposed at the same position as the first cell boundary (CB_X1) of the first standard cell (SC1) in a second direction (Y) that is parallel with the upper surface of the substrate (710) and intersects the first direction (X).

12. The integrated circuit (600A, 600B) of any one of claims 1 to 11, further comprising:
a third standard cell (SC3) between the first standard cell (SC1) and the second standard cell (SC2) in the first direction (X).

13. The integrated circuit (600A, 600B) of any one of claims 12, wherein
the first standard cell (SC1) and the second standard cell (SC2) are adjacent in the first direction (X), and
wherein the second conductive layer (623) and the third conductive layer (633) are spaced apart from each other in a second direction (Y) that is parallel with the upper surface of the substrate (710) and intersects the first direction (X).

## Amended claims

### Amended claims in accordance with Rule 137(2) EPC.

1. An integrated circuit (600A, 600B), comprising:
a substrate (710);
an insulating layer (740) on a first surface of the substrate (710);
a first conductive layer (613) that extends in a first direction (X) in the insulating layer (740), wherein the first direction (X) is parallel with an upper surface of the substrate (710);
a second conductive layer (623) that extends in the first direction (X) in a same layer as the first conductive layer (613);
a third conductive layer (633) that extends in the first direction (X) in the same layer as the first conductive layer (613);
a first standard cell (SC1) that includes a first cell boundary (CB _X1) in the insulating layer (740) and is configured to be supplied with a power voltage from a power distribution network, PDN, on a second surface of the substrate (710) that is opposite to the first surface; and
a second standard cell (SC2),
wherein the first conductive layer (613) overlaps the first cell boundary (CB_X1) in the first direction (X),
wherein the second conductive layer (623) is electrically connected to the first conductive layer (613) and is configured to provide an output pin that outputs a signal that transitions to a plurality of voltage levels of the first standard cell (SC1), and
wherein the third conductive layer (633) is electrically connected to the first conductive layer (613) and is configured to provide an input pin that receives a signal from the second standard cell (SC2).

2. The integrated circuit (600A, 600B) of claim 1, wherein
the first standard cell (SC1) further includes a second cell boundary (CB_X2) that extends in the first direction (X), and
wherein the second conductive layer (623) is between the first cell boundary (CB_X1) and the second cell boundary (CB_X2) in a second direction (Y) that is parallel with the upper surface of the substrate (710) and intersects the first direction (X).

3. The integrated circuit (600A, 600B) of claim 1 or 2, wherein
the first conductive layer (613), the second conductive layer (623), and the third conductive layer (633) are spaced apart from each other in a second direction (Y) that is parallel with the upper surface of the substrate (710) and intersects the first direction (X).

4. The integrated circuit (600A, 600B) of any one of claims 1 to 3, wherein
the first standard cell (SC1) further includes a second cell boundary (CB_X2) that extends in the first direction (X)
wherein the second standard cell (SC2) includes a third cell boundary (CB_X2) and a fourth cell boundary (CB_X3) that extends in the first direction (X), and
wherein the second conductive layer (623) is between the first cell boundary (CB_X1) and the second cell boundary (CB_X2) in the second direction (Y) and the third conductive layer (633) is between the third cell boundary (CB_X2) and the fourth cell boundary (CB_X3) in the second direction (Y).

5. The integrated circuit (600A, 600B) of any one of claims 1 to 4, wherein
a first width (W2) of the first conductive layer (613) is different from a second width (W3) of the second conductive layer (623).

6. The integrated circuit (600A, 600B) of claim 5, wherein
the first width (W2) of the first conductive layer (613) is different from a third width (W4) of the third conductive layer (633).

7. The integrated circuit (600A, 600B) of claim 6, wherein
the first width (W2) of the first conductive layer (613) is greater than the second width (W3) of the second conductive layer (623) and the third width (W4) of the third conductive layer (633).

8. The integrated circuit (600A, 600B) of any one of claims 1 to 7, wherein
the first conductive layer (613) has a first width (W2) and a second width (W1) that is different from the first width (W2).

9. The integrated circuit (600A, 600B) of any one of claim 1 to 8, further comprising:
a fourth conductive layer on the first conductive layer (613) and the second conductive layer (623), wherein the fourth conductive layer electrically connects the first conductive layer (613) and the second conductive layer (623); and
a fifth conductive layer on the first conductive layer (613) and the third conductive layer (633), wherein the fifth conductive layer electrically connects the first conductive layer (613) and the third conductive layer (633).

10. The integrated circuit (600A, 600B) of claim 9, further comprising:
a sixth conductive layer below the second conductive layer (623), wherein the sixth conductive layer is configured to supply a power voltage to the first standard cell (SC1) through a first source/drain pattern that is electrically connected to the second conductive layer (623) and a second source/drain pattern that is spaced apart from the first source/drain pattern in the first direction (X).

11. The integrated circuit (600A, 600B) of any one of claims 1 to 10, wherein
the second standard cell (SC2) further includes a second cell boundary (CB_X2) extending in the first direction (X), wherein the second cell boundary (CB_X2) is disposed at the same position as the first cell boundary (CB_X1) of the first standard cell (SC1) in a second direction (Y) that is parallel with the upper surface of the substrate (710) and intersects the first direction (X).

12. The integrated circuit (600A, 600B) of any one of claims 1 to 11, further comprising:
a third standard cell (SC3) between the first standard cell (SC1) and the second standard cell (SC2) in the first direction (X).

13. The integrated circuit (600A, 600B) of any one of claims 12, wherein
the first standard cell (SC1) and the second standard cell (SC2) are adjacent in the first direction (X), and
wherein the second conductive layer (623) and the third conductive layer (633) are spaced apart from each other in a second direction (Y) that is parallel with the upper surface of the substrate (710) and intersects the first direction (X).
